# EUROPEAN PATENT SPECIFICATION

(11) **EP 1 434 209 B1**
(45) Date of publication and mention of the grant of the patent: **09.04.2008**
(21) Application number: 03258138.1
(22) Date of filing: 22.12.2003
(51) Int. Cl.: G11B 7/125

(54) **Laser diode module with integrated drive chip and optical pickup apparatus adopting the same**
Laserdiodenmodul mit integriertem Ansteuerchip und damit versehenes optisches Abtastgerät
Module à diode laser sur un circuit intégré de commande et appareil de lecture optique muni d'un tel ensemble

(30) Priority: 27.12.2002 KR 2002085445
(43) Date of publication of application: 30.06.2004
(73) Proprietor: SAMSUNG ELECTRONICS CO., LTD., Suwon-si, Gyeonggi-do (KR)
(72) Inventor: Park, Ki-jae, 108-212 Woncheon Jugong Apt.,, Suwon-si, Gyeonggi-do (KR); Lee, Ju-hyuung, 110-2005 Dongsuwon, Suwon-si, Gyeonggi-do (KR); Seong, Pyong-yong, Songpa-gu Seoul (KR)
(74) Representative: Robinson, Ian Michael

(56) References cited:
- JP-A- 10 144 988
- JP-A- 11 185 273
- US-B1- 6 410 904

## Description

The present invention relates to a laser diode module and an optical pickup apparatus adopting the same.

In general, optical pickup apparatuses read/write information with respect to an optical recording medium in a non-contact manner by using light. The optical pickup apparatus adopts a laser diode as a light source which generates and emits light having a predetermined wavelength. A laser diode drive chip is used to control the optical output and on/off of the laser diode.

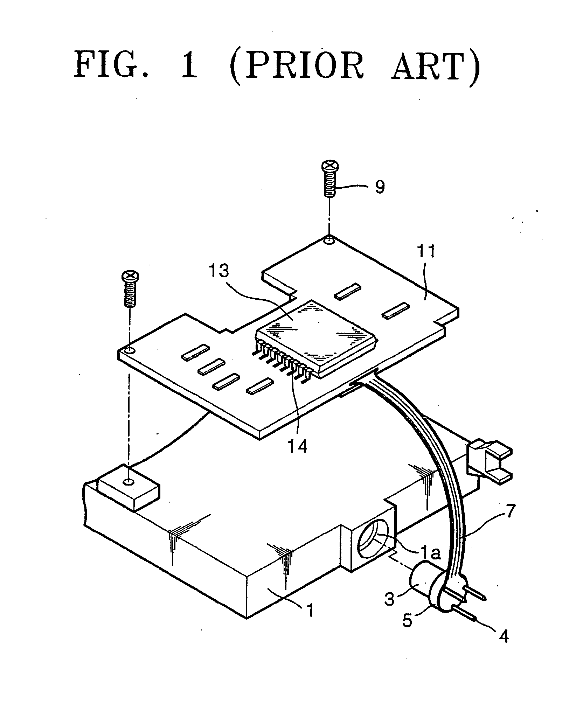

Figure 1 is an exploded perspective view illustrating a conventional laser diode module and a drive chip.

Referring to Figure 1, a laser diode module 3 is coupled to a predetermined position of a mobile member 1. An installation hole 1a is provided in the mobile member 1, and the laser diode module 3 is installed in the installation hole 1a.

The laser diode module 3 includes a plurality of leads 4 which are electrically connected to a drive chip 13. The leads 4 are electrically coupled to an auxiliary board 5, provided at the rear surface of the laser diode module 3, by soldering. The auxiliary board 5 is electrically connected to a main board 11 by a ribbon cable 7.

The main board 11 is installed on the upper portion of the mobile member 1 by a plurality of screws 9. The drive chip 13, which is used to drive the laser diode module 3, is mounted on the upper portion of the main board 11. The drive chip 13 includes a plurality of leads 14 and each of the leads 14 is electrically connected to a land (not shown) provided on the main board 11 by soldering.

The main board 11 is connected to the auxiliary board 5 by the ribbon cable 7. The leads 4 of the laser diode module 3 are electrically connected to the leads 14 of the drive chip 13 indirectly by a wiring provided on the main board 11.

In the above structure of coupling the conventional laser diode module and drive chip, since the distance between the laser diode module and the drive chip is long, the laser diode module and the drive chip are connected by a cable. Thus, while an electric power is applied to the laser diode, there is a possibility of being affected by external noise. Also, since the leads of the laser diode are exposed outwardly, the laser diode is susceptible to static electricity.

Further, since the mobile member and the main board are assembled in a state in which the laser diode module and the main board are separated and are electrically connected by the ribbon cable, assembly is complicated and a manufacturing cost is high.

JP 10 144988 A (Hitachi Tobu Semiconductor Limited) discloses a laser diode module which aims to reduce the number of parts and associated cost. The precharacterising portion of the appended claims are based on this document.

According to the present invention there is provided an apparatus as set forth in the appended claims. Preferred features of the invention will be apparent from the dependent claims, and the description which follows.

The present invention provides a drive chip integrated laser diode module in which a drive chip used to drive a laser diode is integrally formed so that the assembly thereof is simplified and a manufacturing cost is reduced, and an optical pickup apparatus adopting the same.

Additional aspects and/or advantages of the invention will be set forth in part in the description which follows and, in part, will be obvious from the description, or may be learned by practice of the invention.

For a better understanding of the invention, and to show how embodiments of the same may be carried into effect, reference will now be made, by way of example, to the accompanying diagrammatic drawings in which:
Figure 1 is an exploded perspective view illustrating a conventional laser diode module and a drive chip;
Figure 2 is an exploded perspective view illustrating a drive chip integrated laser diode module according to an embodiment of the present invention;
Figure 3 is a sectional view illustrating the drive chip integrated laser diode module of Figure 2;
Figure 4 is an exploded perspective view illustrating a state of assembling the drive chip integrated laser diode module of Figure 2 to an optical pickup; and
Figure 5 is a perspective view illustrating an optical pickup adopting the drive chip integrated laser diode module of Figure 2.

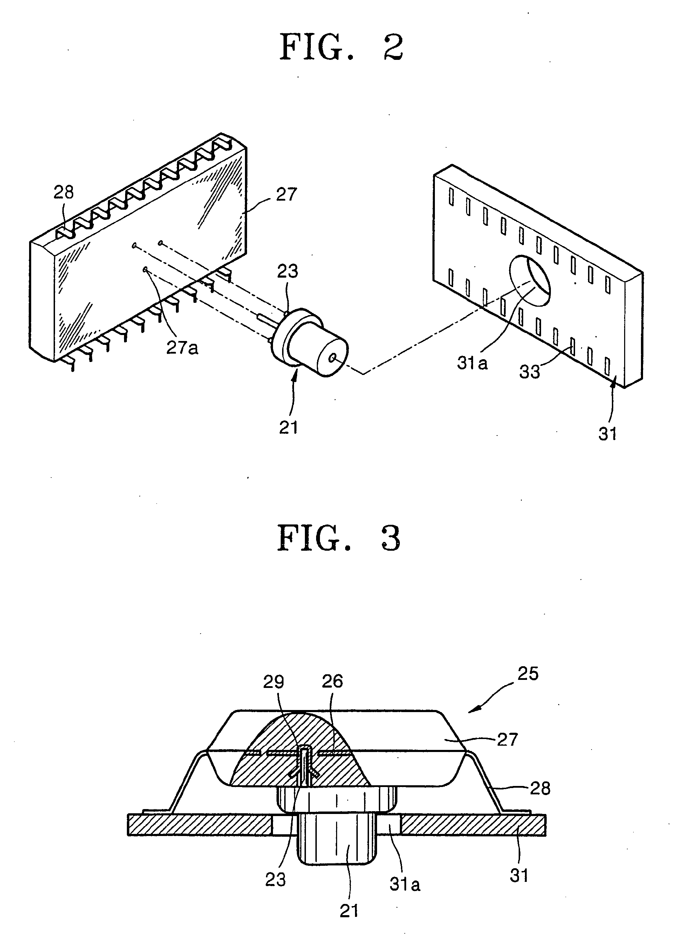

Referring to Figures 2 and 3, a drive chip integrated laser diode module according to an embodiment of the present invention includes a laser diode module main body 21 which generates and emits laser light, a drive chip 25 which drives the laser diode module main body 21, and a main board 31. The drive chip 25 and the main board 31 are integrally coupled with respect to the laser diode module main body 21.

The laser diode module main body 21 includes a laser diode (not shown) inside the laser diode module main body 21, and a plurality of first leads 23 protruding outwardly to apply electric power to the laser diode. Since the structure of the laser diode module main body 21 is well known in the art, a detailed description thereof is omitted.

The drive chip 25 is packaged with a mold resin 27 in a state in which a semiconductor device is mounted on a lead frame 26, and includes a plurality of second leads 28 protruding outwardly. Also, a plurality of coupling holes 27a, into which the first leads 23 are inserted, are formed in the mold resin 27. Inner connectors 29, to which each of the first leads 23 are respectively electrically connected, are formed in each of the coupling holes 27a.

The second leads 28 are electrically connected to a plurality of lands 33 provided on the main board 31. The inner connectors 29, which correspond to the first leads 23 connected to the laser diode module main body of the conventional drive chip 13 of Figure 1, are provided in the mold resin 27 without protruding outwardly from the coupling holes 27a. Also, the inner connectors 29 have a predetermined shape as shown in Figure 3, so that an end portion of the first lead 23 is inserted.

The main board 31 has the lands 33 electrically connected to the second leads 28, and a through hole 31a through which the laser diode module main body 21 passes.

Thus, in a state in which the laser diode module main body 21 is coupled to the rear surface of the drive chip 25, the main board 31 is directly coupled to the rear surface of the drive chip 25 so that the structure may be made compact. Since part of the laser diode module main body 21 protrudes through the through hole 31a provided at the main board 31, mechanical interference and optical interference can be avoided.

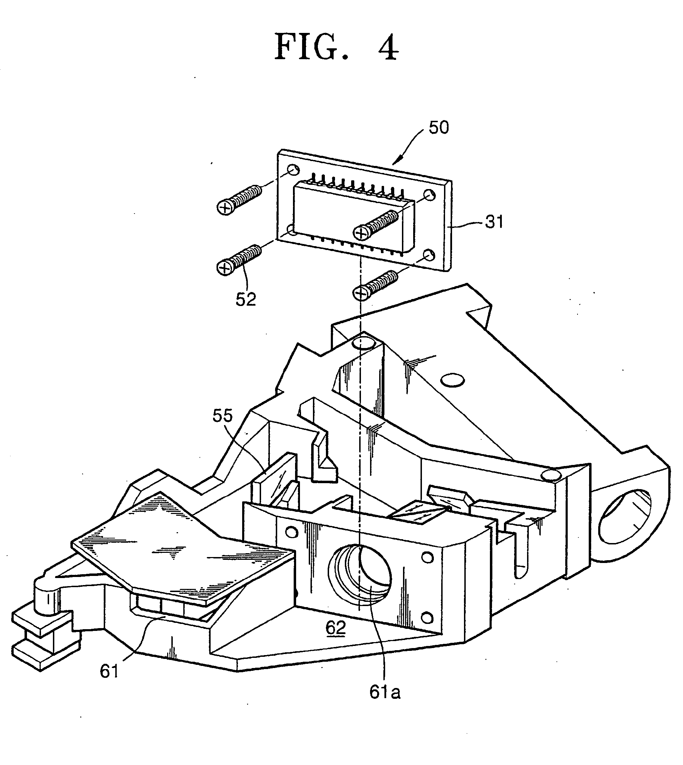

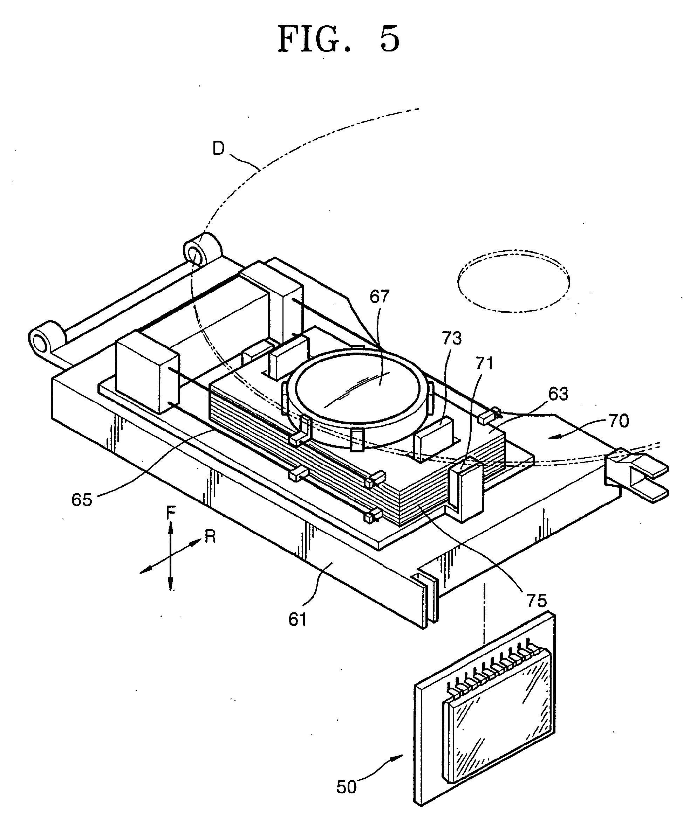

Referring to Figures 4 and 5, an optical pickup apparatus according to an embodiment of the present invention includes a base 61, a laser diode module 50, and a photodetector 55 provided on the base 61, a bobbin 63 movably installed on the base 61 by a suspension 65, an objective lens 67 mounted on the bobbin 63, and a magnetic actuating unit 70 which actuates the bobbin 63 with respect to the base 61.

The laser diode module 50 includes the laser diode module main body 21, the drive chip 25, and the main board 31, which are integrally formed. Since the structure and arrangement thereof are described above, a detailed description thereof is omitted.

The base 61 is movable in a radial direction of an optical recording medium D, and includes an installation portion 62 where the drive chip laser diode module 50 is installed, and an installation hole 61a formed in the base 61 which receives the laser diode module main body 21 of Figure 2.

In installing the drive chip integrated laser diode module 50 with respect to the base 61, the main board 31 is coupled to the installation portion 62 by using a screw 52. Thus, since heat generated by the laser diode module 50 is dissipated through the screw 52 and the base 61, a heat generation problem due to the inner connectors 29 of Figure 3 provided inside may be solved.

As another possible solution to the heat problem, the laser diode module main body 21 of Figure 3 may be coupled in the installation hole 61a so as to contact an inner wall of the installation hole 61a provided on the base 61. In this case, the heat generated from the laser diode module 50 may be dissipated through the base 61.

The bobbin 63 is installed to be able to move by the suspension 65 above the base 61 in a track direction R and a focus direction F of the optical recording medium D. The objective lens 67 is mounted on the bobbin 63, and focuses the light emitted from the laser diode module 50 on the optical recording medium D.

The magnetic actuating unit 70 is arranged across the base 61 and the bobbin 63, and actuates the objective lens 67 in the track direction R and the focus direction F by using an electromagnetic force. The magnetic actuating unit 70 includes a magnet 71, a yoke 73, and a coil member 75. A detailed description thereof is omitted because the structure and operation thereof are well known.

The photodetector 55 may be provided on the base 61, and detects an information signal, a tracking error signal, and a focusing error signal by receiving the light reflected by the optical recording medium D.

As described above, in the drive chip integrated laser diode module according to the present invention, since the drive chip needed to drive the laser diode is integrally formed, assembly time can be reduced. Also, since the drive chip and the laser diode module are directly connected, an additional cable to connect them is not needed, so that manufacturing cost can be reduced.

Thus, in the optical pickup apparatus according to the present invention, by adopting a drive chip integrated laser diode module as a light source module, the assembly time and the manufacturing cost may be reduced.

Although a few preferred embodiments have been shown and described, it will be appreciated by those skilled in the art that various changes and modifications might be made without departing from the scope of the invention, as defined in the appended claims.

## Claims

1. A laser diode module comprising:
a laser diode module main body (21) to generate and emit laser light;
a drive chip (25) to drive the laser diode module main body (21); and
a main board (31);
wherein the drive chip (25) and the main board (31) are integrally coupled with respect to the laser diode module main body (21);
**characterised in that**:
the drive chip (25) is packaged with a mold resin (27) in a state in which a semiconductor device is mounted on a lead frame.

2. The laser diode module of claim 1, wherein the laser diode module main body (21) comprises:
a laser diode inside the laser diode module main body (21); and
a plurality of laser diode leads (23) protruding outwardly to apply electric power to the laser diode.

3. The laser diode module of claim 2, further comprising a plurality of coupling holes (27a) formed in the mold resin (27) of the drive chip (25), wherein the plurality of laser diode leads (23) are respectively inserted into the coupling holes (27a).

4. The laser diode module of claim 3, further comprising a plurality of inner connectors (29) formed in each of the coupling holes (27a), respectively, wherein each of the laser diode leads (23) are respectively electrically connected.

5. The laser diode module of claim 4, wherein the inner connectors (29) are provided in the mold resin (27) without protruding outwardly from the coupling holes (27a).

6. The laser diode module of claim 4 or 5, wherein the inner connectors (29) have a predetermined shape in which end portions of the laser diode leads (23) are inserted.

7. The laser diode module of any preceding claim,
wherein the drive chip (25) further comprises a plurality of drive chip leads (28) protruding outwardly.

8. The laser diode module of claim 7, further comprising a plurality of lands (33) provided on the main board (31), wherein the drive chip leads (28) are electrically connected to the lands (33).

9. The laser diode module of any preceding claim, further comprising a through hole (31a) in the main body (31) through which the laser diode module main body (21) passes.

10. The laser diode module of any preceding claim,
wherein the main board (31) is directly coupled to a surface of the drive chip (25) so that the structure is made compact.

11. The laser diode module of any preceding claim, comprising:
a plurality of first leads (23) protruding outwardly from the laser diode module main body (21) to receive electric power;
a plurality of coupling holes (27a) in the drive chip (25) in which each of the first leads (23) is inserted, respectively;
a plurality of inner connectors (29) in the drive chip (25), electrically connected to each of the first leads (23), respectively;
a plurality of second leads (28) protruding outwardly from the drive chip (25);
a plurality of lands (33) provided on the main board (31), electrically connected to the second leads (28); and
a through hole (31a) in the main board (31) through which the laser diode module main body (21) passes;
wherein the drive chip (25) and the main board (31) are integrally formed with respect to the laser diode module main body (21).

12. The laser diode module of any preceding claim,
wherein the main board (31) is directly coupled to the rear surface of the drive chip (25) so that the structure is made compact.

13. An optical pickup apparatus, comprising:
a base (61) to reciprocate in a radial direction of an optical recording medium; and
a laser diode module (50) as set forth in any preceding claim;
wherein the laser diode module (50) is coupled to the base (61) so as to dissipate heat generated by the laser diode module (50).

14. The optical pickup apparatus of claim 13, further comprising an installation hole (61a) in the base (61),
wherein the laser diode module main body (21) contacts an inner wall of the installation hole (61a) to dissipate heat from the drive chip integrated laser diode module (50) to the base (61).

15. The optical pickup apparatus of claim 13 or 14
wherein the drive chip integrated laser diode module (50) is coupled to the base (61) by a heat dissipating member (52) to dissipate heat generated by the drive chip integrated laser diode module (50).

16. The optical pickup apparatus of claim 15, wherein the dissipating member (52) is a screw.

17. The optical pickup apparatus of any of claims 13 to 16, comprising:
a bobbin (63) connected to the base (61) through a suspension (65), and movably installed in a track direction and a focus direction of an optical recording medium above the base (61);
an objective lens (67) mounted on the bobbin (63) to focus light emitted from the laser diode module (50) on the optical recording medium;
a magnetic actuating unit (70) provided across the base (61) and the bobbin (63) to actuate the objective lens (67) in the track direction and the focus direction of the optical recording medium; and
a photodetector (55) provided on the base (61) to detect an information signal and an error signal by receiving light reflected by the optical recording medium.

## Patentansprüche

1. Laserdioden-Modul, das umfasst:
einen Hauptkörper (21) des Laserdioden-Moduls zum Erzeugen und Emittieren von Laserlicht;
einen Ansteuer-Chip (25) zum Ansteuern des Hauptkörpers (21) des Laserdioden-Moduls; und
eine Hauptplatine (31);
wobei der Ansteuer-Chip (25) und die Hauptplatine (31) in Bezug auf den Hauptkörper (21) des Laserdioden-Moduls integral gekoppelt sind;
**dadurch gekennzeichnet, dass**:
der Ansteuer-Chip (25) in ein Formharz (27) in einem Zustand eingeschlossen ist, in dem eine Halbleitervorrichtung an einem Leiterrahmen angebracht ist.

2. Laserdioden-Modul nach Anspruch 1, wobei der Hauptkörper (21) des Laserdioden-Moduls umfasst:
eine Laserdiode im Inneren des Hauptkörpers (21) des Laserdioden-Moduls; und
eine Vielzahl von Laserdioden-Zuleitungen (23), die zum Anlegen von elektrischem Strom an die Laserdiode nach außen vorstehen.

3. Laserdioden-Modul nach Anspruch 2, das des Weiteren eine Vielzahl von Kopplungslöchern (27a) umfasst, die in dem Formharz (27) des Ansteuer-Chips (25) ausgebildet sind, wobei die Vielzahl von Laserdioden-Zuleitungen (23) jeweils in die Kopplungslöcher (27a) eingeführt sind.

4. Laserdiodenmodul nach Anspruch 3, das des Weiteren eine Vielzahl innerer Verbinder (29) umfasst, die jeweils in jedem der Kopplungslöcher (27a) ausgebildet sind, wobei jede der Laserdioden-Zuleitungen (23) jeweils elektrisch verbunden ist.

5. Laserdioden-Modul nach Anspruch 4, wobei die inneren Verbinder (29) in dem Formharz (27) vorhanden sind, ohne aus den Kopplungslöchern (27a) nach außen vorzustehen.

6. Laserdioden-Modul nach Anspruch 4 oder 5, wobei die inneren Verbinder (29) eine vorgegebene Form haben, in die Endabschnitte der Laserdioden-Zuleitungen (23) eingeführt sind.

7. Laserdioden-Modul nach einem der vorangehenden Ansprüche, wobei der Ansteuer-Chip (25) des Weiteren eine Vielzahl von Zuleitungen (28) des Ansteuer-Chips umfasst, die nach außen vorstehen.

8. Laserdioden-Modul nach Anspruch 7, das des Weiteren eine Vielzahl von Stegen (33) umfasst, die an der Hauptplatine (31) vorhanden sind, wobei die Zuleitungen (28) des Ansteuer-Chips elektrisch mit den Stegen (33) verbunden sind.

9. Laserdioden-Modul nach einem der vorangehenden Ansprüche, das des Weiteren ein Durchgangsloch (31 a) in dem Hauptkörper (31) umfasst, durch das der Hauptkörper (21) des Laserdioden-Moduls hindurchtritt.

10. Laserdioden-Modul nach einem der vorangehenden Ansprüche, wobei der Hauptkörper (31) direkt mit einer Oberfläche des Ansteuer-Chips (25) verbunden ist, so dass die Struktur kompakt wird.

11. Laserdioden-Modul nach einem der vorangehenden Ansprüche, das umfasst:
eine Vielzahl erster Zuleitungen (23), die von dem Hauptkörper (21) des Laserdioden-Moduls nach außen vorstehen, um elektrischen Strom aufzunehmen;
eine Vielzahl von Kopplungslöchern (27a) in dem Ansteuer-Chip (25), in die jeweils jede der ersten Zuleitungen (23) eingeführt ist;
eine Vielzahl innerer Verbinder (29) in dem Ansteuer-Chip (25), die jeweils mit jeder der ersten Zuleitungen (23) verbunden sind;
eine Vielzahl zweiter Zuleitungen (28), die von dem Ansteuer-Chip (25) nach außen vorstehen;
eine Vielzahl von Stegen (33), die an der Hauptplatine (31) vorhanden und elektrisch mit den zweiten Zuleitungen (28) verbunden sind; und
ein Durchgangsloch (31 a) in dem Hauptkörper (31), durch das der Hauptkörper (21) des Laserdioden-Moduls hindurchtritt;
wobei der Ansteuer-Chip (25) und die Hauptplatine (31) in Bezug auf den Hauptkörper (21) des Laserdioden-Moduls integral ausgebildet sind.

12. Laserdioden-Modul nach einem der vorangehenden Ansprüche, wobei die Hauptplatine (31) direkt mit der Rückseite des Ansteuer-Chips (25) gekoppelt ist, so dass die Struktur kompakt wird.

13. Optische Abnehmervorrichtung, die umfasst:
einen Träger (61), der sich in einer radialen Richtung eines optischen Aufzeichnungsmediums hin und her bewegt; und
ein Laserdioden-Modul (50) nach einem der vorangehenden Ansprüche;
wobei das Laserdioden-Modul (50) so mit dem Träger (61) verbunden ist, dass durch das Laserdioden-Modul (50) erzeugte Wärme abgeleitet wird.

14. Optische Abnehmervorrichtung nach Anspruch 13, die des Weiteren ein Installationsloch (61 a) in dem Träger (61) umfasst, wobei der Hauptkörper (21) des Laserdioden-Moduls mit einer Innenwand des Installationslochs (61 a) in Kontakt kommt, um Wärme von dem integral mit dem Ansteuer-Chip ausgebildeten Laserdioden-Modul (50) zu dem Träger (61) abzuleiten.

15. Optische Abnehmervorrichtung nach Anspruch 13 oder 14, wobei das integral mit dem Ansteuer-Chip ausgebildete Laserdioden-Modul (50) durch ein Wärmeableitelement (52) mit dem Träger (61) gekoppelt ist, um durch das integral mit dem Ansteuer-Chip ausgebildete Laserdioden-Modul (50) erzeugte Wärme abzuleiten.

16. Optische Abnehmervorrichtung nach Anspruch 15, wobei das Ableitelement (52) eine Schraube ist.

17. Optische Abnehmervorrichtung nach einem der Ansprüche 13 bis 16, die umfasst:
einen Spulenkörper (63), der mit dem Träger (61) über eine Aufhängung (65) verbunden ist und in einer Spurrichtung sowie einer Fokusrichtung eines optischen Aufzeichnungsmediums über dem Träger (61) beweglich installiert ist;
eine Objektivlinse (67), die an dem Spulenkörper (63) angebracht ist, um von dem Laserdioden-Modul (50) emittiertes Licht auf dem optischen Aufzeichnungsmedium zu fokussieren;
eine Magnet-Betätigungseinheit (70), die über den Träger (61) und den Spulenkörper (63) vorhanden ist, um die Objektivlinse (67) in der Spurrichtung und der Fokusrichtung des optischen Aufzeichnungsmediums zu betätigen; und
einen Fotodetektor (55), der an dem Träger (61) vorhanden ist, um ein Informationssignal und ein Fehlersignal durch Empfangen von Licht zu erfassen, das von dem optischen Aufzeichnungsmedium reflektiert wird.

## Revendications

1. Module à diode laser comprenant :
un corps principal de module à diode laser (21) pour produire et émettre une lumière laser ;
un circuit de commande (25) pour commander le corps principal de module à diode laser (21) ; et
une plaquette principale (31) ;
le circuit de commande (25) et la plaquette principale (31) étant couplés d'une seule pièce par rapport au corps principal de module à diode laser (21) ;
**caractérisé en ce que** le circuit de commande (25) est enveloppé avec une résine de moulage (27) dans une position dans laquelle un dispositif à semi-conducteur est monté sur une grille de connexion.

2. Module à diode laser selon la revendication 1, dans lequel le corps principal de module à diode laser (21) comprend :
une diode laser à l'intérieur dudit corps principal (21) ; et
plusieurs fils de diode laser (23) qui dépassent vers l'extérieur pour appliquer une énergie électrique à la diode laser.

3. Module à diode laser selon la revendication 2, comprenant également plusieurs trous de couplage (27a) qui sont formés dans la résine de moulage (27) du circuit de commande (25), les fils de diode laser (23) étant insérés dans ces trous de couplage (27a) respectifs.

4. Module à diode laser selon la revendication 3, comprenant également plusieurs connecteurs intérieurs (29) qui sont formés dans les trous de couplage (27a) respectifs, chacun des fils de diode laser (23) étant relié électriquement.

5. Module à diode laser selon la revendication 4, dans lequel les connecteurs intérieurs (29) sont disposés dans la résine de moulage (27) sans dépasser des trous de couplage (27a) vers l'extérieur.

6. Module à diode laser selon la revendication 4 ou 5, dans lequel les connecteurs intérieurs (29) ont une forme prédéterminée dans laquelle les parties d'extrémité des fils de diode laser (23) sont insérées.

7. Module à diode laser selon l'une quelconque des revendications précédentes, dans lequel le circuit de commande (25) comprend également plusieurs fils de circuit de commande (28) qui dépassent vers l'extérieur.

8. Module à diode laser selon la revendication 7, comprenant également plusieurs pastilles de liaison (33) disposées sur la plaquette principale (31), les fils de circuit de commande (28) étant reliés électriquement à ces pastilles (33).

9. Module à diode laser selon l'une quelconque des revendications précédentes, comprenant également dans la plaquette principale (31) un trou traversant (31a) par lequel passe le corps principal de module à diode laser (21).

10. Module à diode laser selon l'une quelconque des revendications précédentes, dans lequel la plaquette principale (31) est couplée directement à une surface du circuit de commande (25), ce qui rend la structure compacte.

11. Module à diode laser selon l'une quelconque des revendications précédentes, comprenant:
plusieurs premiers fils (23) qui dépassent, vers l'extérieur, du corps principal de module à diode laser (21) pour recevoir l'énergie électrique ;
plusieurs trous de couplage (27a) prévus dans le circuit de commande (25), dans lesquels les premiers fils (23) respectifs sont insérés ;
plusieurs connecteurs intérieurs (29) prévus dans le circuit de commande (25) et reliés électriquement aux premiers fils (23) respectifs ;
plusieurs seconds fils (28) qui dépassent, vers l'extérieur, du circuit de commande (25) ;
plusieurs pastilles de liaison (33) qui sont disposées sur la plaquette principale (31) et qui sont reliées électriquement aux seconds fils (28) ; et
un trou traversant (31a) qui est prévu dans la plaquette principale (31) et par lequel passe le corps principal de module à diode laser (21) ;
le circuit de commande (25) et la plaquette principale (31) étant formés d'une seule pièce par rapport au corps principal de module à diode laser (21).

12. Module à diode laser selon l'une quelconque des revendications précédentes, dans lequel la plaquette principale (31) est couplée directement à la surface arrière du circuit de commande (25), ce qui rend la structure compacte.

13. Appareil de lecture optique comprenant:
une base (61) destinée à décrire un mouvement de va-et-vient dans un sens radial d'un support d'enregistrement optique ; et
un module à diode laser (50) selon l'une quelconque des revendications précédentes ;
le module à diode laser (50) étant couplé à la base (61) de manière à dissiper la chaleur produite par le module à diode laser (50).

14. Appareil de lecture optique selon la revendication 13, comprenant également un trou d'installation (61a) prévu dans la base (61), le corps principal de module à diode laser (21) étant en contact avec une paroi intérieure du trou d'installation (61a) afin de dissiper vers la base (61) la chaleur provenant du module à diode laser (50) à circuit de commande intégré.

15. Appareil de lecture optique selon la revendication 13 ou 14, dans lequel le module à diode laser (50) à circuit de commande intégré est couplé à la base (61) grâce à un élément de dissipation de chaleur (52) afin de dissiper la chaleur produite par ledit module à diode laser (50) à circuit de commande intégré.

16. Appareil de lecture optique selon la revendication 15, dans lequel l'élément de dissipation (52) est constitué par une vis.

17. Appareil de lecture optique selon l'une quelconque des revendications 13 à 16, comprenant:
une bobine (63) qui est reliée à la base (61) grâce à une suspension (65) et qui est installée mobile dans un sens de piste et dans un sens de focalisation d'un support d'enregistrement optique au-dessus de la base (61) ;
une lentille d'objectif (67) qui est montée sur la bobine (63) pour focaliser la lumière émise par le module à diode laser (50) sur le support d'enregistrement optique ;
une unité d'actionnement magnétique (70) qui est disposée sur la base (61) et sur la bobine (63) pour actionner la lentille d'objectif (67) dans le sens de piste et dans le sens de focalisation du support d'enregistrement optique ; et
un photodétecteur (55) qui est disposé sur la base (61) pour détecter un signal d'information et un signal d'erreur en recevant la lumière réfléchie par le support d'enregistrement optique.
